# EUROPEAN PATENT APPLICATION

(11) **EP 3 340 420 A1**
(43) Date of publication of application: **27.06.2018**
(21) Application number: 16205941.4
(22) Date of filing: 21.12.2016
(51) Int. Cl.: H02J 7/00, H04M 1/04, H02J 50/12, H05K 7/20

(54) **WIRELESS CHARGER AIR COOLING SYSTEM**

(71) Applicant: Panasonic Automotive & Industrial Systems Europe GmbH, 63225 Langen (DE)
(72) Inventor: ZBIBA, Karim, 63225 Langen (DE); GRANDE, Salvatore, 63225 Langen (DE)
(74) Representative: Grünecker Patent- und Rechtsanwälte PartG mbB

(57) **Abstract**

The present invention relates to a cooling device for an inductive charger for automotive as well as consumer applications. The cooling device is effective for guiding cool air towards an electric appliance positioned for performing inductive charging. In particular, the cooling device according to the present invention is suitable for charging electronic appliances such as smart phones or tablet computers. The cooling device enables an effective cooling concept which allows enhancement of the power of a wireless inductive charger to the order of up to at least 15W.

## Description

### FIELD OF THE INVENTION

The present invention generally relates to the field of wireless charging of electric appliances such as smart phones and tablet computers. More specifically, the present invention relates to a cooling device for enabling cooling of an electric appliance while being charged wirelessly (inductively).

### BACKGROUND ART

The physical principle of electromagnetic induction renders it possible to transmit energy from a first object (primary side) to a second object (secondary side). More specifically, the energy is transmitted from a first inductivity (coil) on the primary side to a second inductivity (coil) on the secondary side. When a time variable electric current flows through the primary coil, a time varying electromagnetic field is generated which induces an electric current in a secondary coil located sufficiently close to the primary coil. Thereby, transmission of electric energy is achieved. In other words, the primary coil and the secondary coil are inductively coupled with each other. A particularly widespread application of wireless energy transmission by electromagnetic induction is the wireless charging (also called inductive charging in view of the underlying physical principle) of an energy storage such as a battery or an accumulator of an electric appliance. An electric appliance that is configured for being inductively charged includes an inductivity, which inductively couples, as a secondary coil, to a primary coil arranged in a charging device.

Inductive charging has a variety of fields of application, such as charging small portable electric devices, for instance mobile phones, in particular, smart phones, or electric toothbrushes, but also applications in the field of electrically powered vehicles. A further field of application is medical technology, wherein batteries in implanted devices such as heart pacemakers or insulin pumps can be wirelessly charged.

The advantages of wireless charging as compared to energy transmission by means of electric current through a conductor are *inter alia* a simple mechanic construction, and the possibility of being used in a wet environment because of the absence of electric currents between the devices, or in situations where no mechanic connection is possible (for example, in implanted devices). On the other hand, there are drawbacks such as lower overall efficiency, or in other words a higher power dissipation, which may result in considerable heat generation.

A plurality of arrangements has been proposed in order to increase efficiency, for instance by optimizing the relative alignment of primary and secondary coils. Nevertheless, heat dissipation remains a problem since too much heat may harm the electrical appliances to be charged, or may not be acceptable for general security reasons.

For this purpose, electric appliances that are adapted for wireless charging are usually equipped with a temperature sensor. When the temperature of the appliance exceeds a predetermined limit during charging, the charging process is automatically interrupted. For instance, in the case of charging mobile phones such as smart phones, a temperature in the range of 50°C is not acceptable. It has to be further noted that the temperature becomes the higher, the less the efficiency is, since a lower charging efficiency means a higher heat dissipation. For instance, there are appliances which do not conduct the inductive charging process, if the primary and secondary coils are not aligned so as to achieve at least a predetermined efficiency, e.g. 70%. However, with a given inductive charging device it cannot be guaranteed that every appliance placed thereon for inductive charging conforms to such a rule. Another problem is the additional heat if the appliance to be charged is exposed to insolation. For such purposes, by means of respective sensors, an interruption of charging must be ensured if the temperature of the appliance to be charged exceeds predetermined limits.

On the other hand, a frequent interruption of the charging process considerably decreases the overall efficiency of the inductive charging, and should therefore be avoided as much as possible. Generally, a limitation in the power with which the charging is performed will limit the heat generation. However, at the same time it decreases the charging speed and thus prevents fast charging.

A particular emerging field where the application of inductive charging becomes promising is automotive technology. Besides the possibility of inductively charging traction batteries mentioned above, there is also a further advantage of such charging technology being used, e.g. for smart phones of users within a vehicle, such as a car driver. Since a smart phone in the future may be increasingly employed for performing certain control functions in a network of electronic devices in a vehicle (such as a component of a vehicle entertainment and information system, navigation system, or air conditioning system) it should be guaranteed that the smart phone included in the network of the vehicle is always fully charged. The vehicle therefore should provide a system for ensuring charging in a fast, simple, free and safe way. Obviously, an inductive charging, not requiring any wired connections, is preferable over charging via a loading current through a wired connection.

However, as indicated above, it is desired to avoid an interruption of the charging process in view of excessive heat generation/high temperature as far as possible. This is particularly crucial for an automotive environment, with its enhanced security requirements. Existing wireless chargers for the automotive field have been limited to low charging powers, such as 5W (Watts).

It is noted, however, that the problem explained above may also occur in other fields such as for wireless chargers employed in a general consumer (household) environment, for instance, for charging smart phones or comparable appliances, such as tablet computers. Similarly to a smart phone in a vehicle, such devices may take over control functions of a variety of household electric appliances, while being inductively charged. Similarly, for a high degree of availability, it is necessary to enable fast charging, as well as to avoid frequent interruption of the charging process due to temperature conditions.

It is therefore desirable to overcome the above drawbacks and to provide a technical solution that enables fast and safe charging of electric appliances, for instance in the automotive and consumer environment.

### SUMMARY OF THE INVENTION

The present invention aims to provide a device that enables fast and safe charging of electric appliances, with enhanced charging power, for instance, in the automotive environment.

This is achieved by the features of the independent claims.

According to an aspect of the present invention, a cooling device for enabling cooling of an electric appliance during inductive charging is provided. The cooling device comprises a contact pad for placing thereon an electric appliance to be charged. The contact pad includes a plurality of air flow holes and a means for establishing a predetermined distance between an upper surface of the contact pad and a lower surface of an electric appliance placed on the contact pad. The cooling device further comprises a flow deviator. The flow deviator comprises a substantially flat structure provided underneath the contact pad so as to be in contact with a lower surface of the contact pad. The flow deviator includes an air inflow opening arranged on a first side of the substantially flat structure and at least one air flow channel formed by walls extending from the lower surface of the contact pad in a thickness direction of the substantially flat structure and connected to said air inflow opening and to at least a part of the flow holes of the contact pad, for conveying the air from the air inflow opening to the at least a part of the air flow holes.

It is the particular approach of the present invention to provide a cooling means for the interface between a charging device for inductive charging and an electric appliance to be charged, such as a smart phone or tablet computer. This allows considerable enhancement of the charging power of the electric charging device while nevertheless avoiding interruption of the charging for overheating reasons. According to the present invention, a cooling device is provided in which the electric appliance to be charged is positioned so that cool air can be conveyed through the physical interface between the charging device and the electric appliance. The cool air is heated by heat dissipation in the charging process and conveys the heat away from the charging system. Hence, an effective thermal exchange is achieved.

Preferably, there is a plurality of air flow channels each of which is connected to a respective plurality of the air holes of the contact pad.

Preferably, the flow deviator further includes a second air flow opening arranged opposite the air inflow opening. The second air flow opening may be either a second air inflow opening or an air exhaust opening. Both versions enhance the efficiency of cold air being conveyed through a space between the upper surface of the contact pad and the electric appliance positioned thereon (wherein the predetermined distance for allowing air circulation is guaranteed by the means for establishing a predetermined distance).

In accordance with a preferred embodiment, the second air flow opening is an air exhaust opening. In such an embodiment, cool air is conveyed from the air inflow opening through one or a plurality of first air flow channels to a first part of the air holes of the contact pad. After having been heated by dissipating heat to be conveyed away, the air is guided through the remaining air holes of the contact pad, forming a second part of the air holes, connected with one or a plurality of second airflow channels to the air exhaust opening. Specifically, the at least one first air flow channel is connected to the first part of the plurality of air flow holes. The at least one second airflow channel is connected to the air exhaust opening. In order to guarantee an effective guiding of the air, the first and second channel/channels must be hermetically (airtightly) sealed with respect to each other. This can be achieved by a board on which the whole structure of the cooling device is mounted so that the walls of the channels extend in the thickness direction from the lower surface of the contact pad to the upper surface of said board. Consequently, the only possible airflow from the first to the second channel(s) is through the first part of the air holes, via the space (gap) between the upper surface of the contact pad and the lower surface of the appliance (such a space is guaranteed by the means for establishing a predetermined distance) and the second part of the air holes. Preferably, there is a plurality of first and second airflow channels extending substantially parallel to each other along a direction connecting the air inflow opening and the air exhaust opening, such that first and second airflow channels alternate respectively in the perpendicular direction. Also preferably, the air inflow opening and the air exhaust opening are connectable to fans. A first fan, connected to the air inflow opening, blows air through the first channel(s) and the first part of the air holes towards the gap. The second fan sucks the air heated in the gap for the second airflow channel(s) towards the air exhaust opening. Thereby, an efficient air flow through the gap can be achieved.

In accordance with an alternative preferred embodiment, the second air flow opening is a further air inflow opening. In such an embodiment, cool air can be blown in from both opposite sides of the charging arrangement, into the gap between the contact pad and the appliance to be charged. A permanent flow of new cool air pushes away the air previously provided, which leaves the gap to the sides thereof. Specifically, in this case there is only a single kind of air flow channel provided, which is connected to both air inflow openings. Preferably there is a plurality of air flow channels that are arranged so as to extend parallel to each other along a direction connecting both air inflow openings. Each of the air flow channels is connected with a respective part of the air holes. Preferably, the air inflow openings are connectable to respective fans for blowing air into the airflow channel. Connection to a fan is also a preferred option in an embodiment, wherein there is only a single air (inflow) opening.

Any fans used for blowing air into a cooling device can be comprised in the cooling device, in accordance with preferred embodiments. Preferably, waterproof fans are used for reasons of liquid resistance.

In embodiments having only a single air flow opening (which is in that case always an air inflow opening), or have two air inflow openings (but do not have an air exhaust opening) in a vehicle, it is an alternative preferred option to connect the air inflow openings to a vehicular air conditioning system for providing the cold air to be blown in, rather than to specifically dedicated fans.

Preferably, the substantially flat structure has a substantially rectangular shape, wherein the opposite sides of the flat structure at which the airflow openings (air inflow opening and second air inflow opening or air exhaust opening) are provided correspond to the smaller edges of the rectangle. For instance, if one imagines a smart phone to be positioned on the contact pad, this means that the cooling air is guided along the lower surface of the smart phone, in a lengthwise direction.

For achieving an efficient inductive coupling, a small distance between transmitting and receiving coils (primary and secondary coils) is preferable. For this purpose, the overall thickness of the cooling device shall be as small as possible, to still guarantee an efficient air flow. In accordance with a preferred embodiment the overall thickness of the substantially flat structure with the contact pad mounted thereon (including the means for establishing the predetermined distance, e.g. pins) is smaller than 5 mm (millimeters). More preferably, the overall thickness is between 3.5 and 4.5 mm.

A cooling device according to the present invention may further comprise a board forming a lower closure of the substantially flat structure. The walls of the air flow channel or air flow channels contact both the board and the contact pad and hence the air can leave the individual air flow channels only through the air holes in the contact pad. In accordance with a preferred embodiment, the bottom board is a printed circuit board for connecting one or a plurality of transmitter coils for the inductive charging of an electric appliance placed on the contact pad. Specifically, a moving coil or multi-coils are arranged underneath the bottom surface of the flow deviator.

The means for establishing a predetermined distance between the upper surface of the contact pad and the lower surface of the electric appliance is preferably realized in the form of a plurality of pins (e.g. rubber pins) forming a plurality of spacers. The electric appliance is placed on the pins, so that an air gap forms between the lower surface thereof and the actual contact pad having the air holes.

Preferably, the individual air holes of the contact pad differ in size. As can be shown by theoretical and experimental investigations, in the case of embodiments without an air exhaust opening, the size of the air holes preferably increases with the distance to the available air inflow openings. Hence, in the case of only a single air inflow hole, the size of the air holes increases from the first side having the air inflow opening towards the opposite end of the cooling device. In the case of two opposing air inflow openings, the size of the air holes increases from both sides towards the middle. However, in embodiments having an air inflow opening and an air exhaust opening, the size of the air holes connected to the first air flow channel(s) increases with increasing distance from the air inflow opening, and the size of the air holes connected to the second air flow channel(s) increases with increasing distance from the air exhaust opening (i.e. decreases with increasing distance from the air inflow opening). All the above indicated patterns ensure that there are almost the same flow conditions along the entire lower surface of the electric appliance.

In accordance with a further particular aspect of the present invention, a wireless charging equipment comprising a cooling device according to the above aspect of the present invention, a board forming a lower closure of the bottom of the substantially flat structure of the flow deviator of the cooling device and one or more transmission coils for transmitting electric energy to an electric appliance placed on the contact pad of the cooling device is provided.

In accordance with a preferred embodiment, the board is a printed circuit board (PCB) having the one or more transmission coils placed thereon and/or connected thereto. In this embodiment, preferably, there are three transmission coils.

In accordance with an alternative preferred embodiment there is a single movable transmission coil. The board is a detection PCB comprising sensing means for sensing placement of an electric appliance on the contact pad and positioning of a receiving coil included in said electric appliance for receiving energy transmitted by said transmission coil. The transmission coil is movably arranged underneath the bottom board, and the sensing means sends a signal to control a moving means for moving the transmission coil in accordance with a sensing result, in order to achieve an optimal alignment of the transmission coil with respect to the receiving coil (auto alignment). The moving means preferably comprises an electric motor and control circuitry for controlling the motor based on a signal received from the sensing means. Also preferably, the sensing means comprises a matrix of small coils (sensing coils). The transmission coil, the moving means and the control circuitry are preferably connected to or mounted on a second PCB different from and located underneath the detection PCB.

Further features and advantages of the present invention are the subject matter of dependent claims.

### BRIEF DESCRIPTION OF THE DRAWINGS

Additional features and advantages of the present invention will become apparent from the following more particular description, as illustrated in the accompanying drawings, wherein:
- Fig. 1: is a perspective view of a cooling device according to embodiments of the present invention;
- Fig. 2: is a perspective view of a flow deviator with attached fans in accordance with a first embodiment of the present invention;
- Fig. 3: shows a top view and a side view of a flow deviator in accordance with the first embodiment of the present invention and illustrates the airflow within the cooling device according to the first embodiment of the present invention;
- Fig. 4: shows a top view of a contact pad of a cooling device in accordance with the first embodiment of the present invention;
- Fig. 5: shows a top view and a side view of the contact pad of a cooling device in accordance with a second embodiment of the present invention;
- Fig. 6: shows an isometric view of a cooling device in accordance with the second embodiment of the present invention;
- Fig. 7: shows a bottom view of a cooling device in accordance with the second embodiment of the present invention;
- Fig. 8: shows a bottom view of a cooling device according to the second embodiment of the present invention illustrating the airflow; and
- Fig. 9: shows a side view of a cooling device according to the second embodiment of the present invention illustrating the airflow.

### DETAILED DESCRIPTION

The present invention generally relates to an air cooling system that allows the cooling of the charging interface between the transmitter coil(s) of a wireless (inductive) charging device (charging unit) and the receiver coil of an electric appliance to be charged, e.g. a smart phone. The system can thus prevent smart phones from overheating and maintain charging without interruption.

In the following, details of non-limiting embodiments of the present invention will be described with reference to drawings. For simplicity and conciseness of the description, terms such as "upper" or "lower", "top" and "bottom" or similar terms are used, although these are, in principle, relative terms which depend on the orientation of the entity described in space. However, a skilled person is aware of a default orientation of the cooling device according to the present invention when in use, since the appliance to be charged (smart phone) must be placed on the contact pad such that the contact pad (more precisely: the upper surface thereof with the spacers/pins for guaranteeing the distance for air circulation) forms the upper portion of the cooling device in said default orientation. Consequently, "lower" designates a portion vertically below the contact pad in the default orientation, "sides" extend in a direction substantially perpendicular to the vertical direction and "flat" means that the vertical dimension is considerably smaller than the side dimensions.

In the following drawings, the same reference numerals relate to the same or similar entities and a detailed description thereof is not repeated, unless there are substantial changes between the individual drawings.

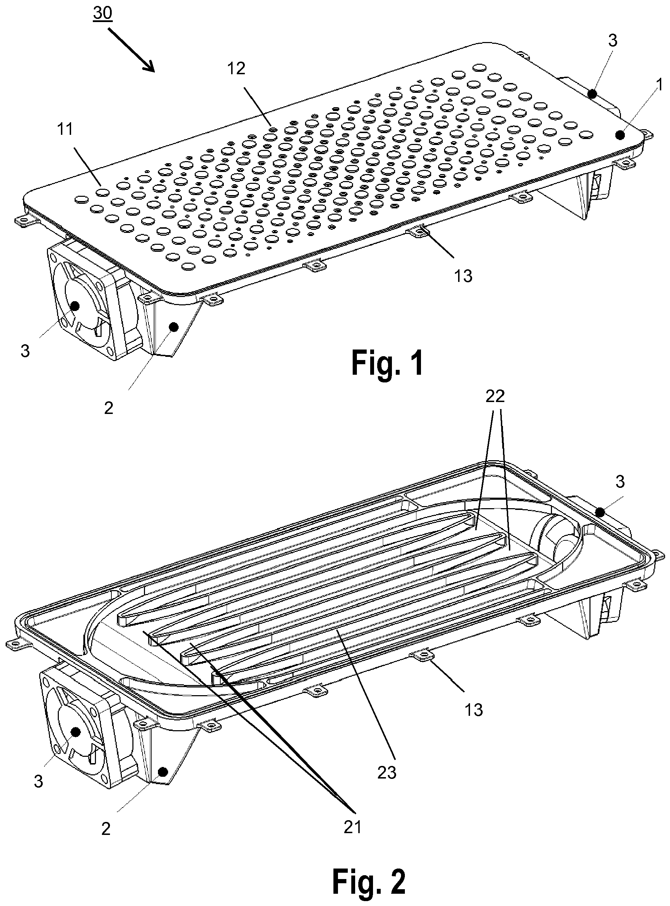

Fig. 1 is a perspective view of the overall design of a cooling device 30 according to embodiments of the present invention.

The cooling device 30 comprises a contact pad 1, a flow deviator 2 and two fans 3.

The contact pad 1 forms the upper conclusion of the overall structure. In embodiments of the invention, the contact pad 1 comprises an upper layer of soft rubber and a bottom layer of hard rubber. Both layers are provided with holes 12 for the passing through of the air that comes from the flow deviator 2. The upper layer, on which the device (such as a mobile phone or tablet) to be charged will be placed is provided with several pins 11 that work like spacers and allow an air circulation between the upper surface of the contact pad 1 and the lower surface of the device to be charged and placed on the contact pad. The choice of soft rubber on the top reduces sliding of the electric appliance, e.g. the mobile phone, on the contact pad 1. In the embodiment, the contact pad has a substantially rectangular shape, which may, for instance, substantially correspond to the rectangular shape of smart phones to be positioned thereon.

The flow deviator 2 is arranged underneath the contact pad. Flow deviator 2 comprises a substantially flat structure and two side portions. The flat structure has the same substantially rectangular shape as the contact pad 1 and the side portions are arranged on the smaller sides of the rectangular shape, so as to extend vertically downwards. In preferred embodiments, at least the contact pad and the flat structure are integrally formed, i.e. in one piece. Alternatively, the substantially flat structure and the contact pad may be formed separately and tightly sealed with respect to each other, in order to avoid air leaks. Preferably, the flow deviator 2 is made of synthetic (plastic) material, such as ABS (Acrylonitrile-Butadiene-Styrene). It has two openings on the small sides. In order to fix the assembly into a box or into a car cockpit, the flow deviator 2 has several drilled ribs 13.

In the illustrated embodiment, the two fans 3 are mounted at the openings. Preferably, the fans 3 are mounted by self tapping screws.

Alternatively, it is also possible to directly connect air conditioning pipes (in a vehicle) to these two openings (not shown).

The following drawings show two different particular embodiments of the present invention.

### (First Embodiment)

A first embodiment is shown in Figs. 2 to 4. The embodiment allows to have two different flows, one from a first fan 3 to the device surface of the appliance to be charged (through a first portion of the holes 12 in the contact pad 1) and another one from the device surface to a second fan 3 (through a second portion of the holes 12 in the contact pad 1).

Fig. 2 shows the assembly of the cooling device without the contact pad on top. Hence, the drawing allows an insight to the structure of the flow deviator 2.

As can be seen therefrom, the substantially flat portion of the flow deviator 2 comprises several air flow channels 21 and 22. A first portion of the channels (21) (in the following: "first channels") serves for conveying the air from the first fan 3 on the left-hand side of the drawing to a first portion of the holes 12 in the contact pad, to which the first channels 21 are connected, i.e. which are situated above the first channels 21 when the flow deviator is closed by the contact pad. A second portion of the channels (22) (in the following: "second channels") serves for conveying the air back from the interface between the contact pad and the electric appliance to the second fan 3 on the right-hand side of the drawing, through a second portion of the holes 12 in the contact pad, to which the second channels 22 are connected, i.e. which are situated above the second channels 22 when the flow deviator is closed by the contact pad.

The first and second air flow channels are formed by walls 23 extending in a thickness (vertical) direction of the substantially flat rectangular structure and further extending in a direction substantially parallel to the sides connecting an air inflow opening on the left-hand side of the rectangular flat structure (connected to the first fan 3) and an air exhaust opening on the right-hand side of the rectangular flat structure (connected to the second fan 3). In the illustrated embodiment, these are the longer sides of the rectangle.

In the embodiment, the walls 23 have three functionalities: the first one is to support the contact pad, the second one is to guide the airflow and the third one is to divide the flow deviator into two main chambers (one connected to the first fan 3 and the other one connected to the second fan 3). For this purpose, the walls have the shape shown in the drawing, i.e. deviating from the parallel direction to the longer sides of the rectangle and approaching each other so as to conclude one side of each channel, thereby avoiding a direct flow from the air inflow opening to the air exhaust opening. Of course, the walls may be integrally formed, of a single piece having the shape illustrated in the drawing.

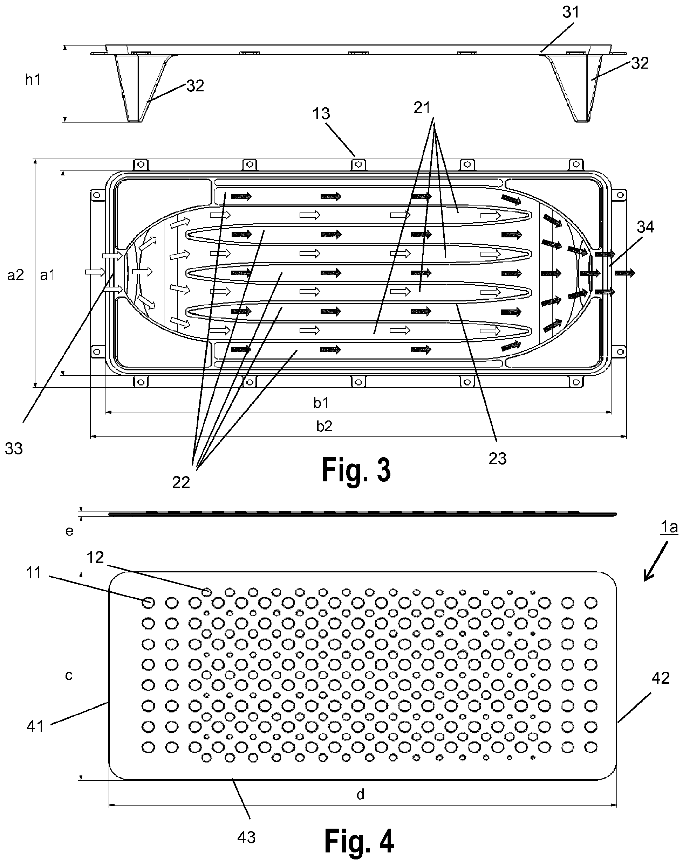

A more detailed illustration of the shape of the cooling device as well as of the airflow is given in Fig. 3.

The top drawing of Fig. 3 shows a side view of a flow deviator according to the first embodiment, viewed from one of the longer sides of the rectangle.

The flow deviator comprises a substantially flat structure 31 and the side portions 32. Thus, the flow deviator has an overturned "U" shape. A typical overall height h1 of the illustrated structure is in the order of 30 to 40 mm. This allows for placing the transmission coils such as a moving coil or a plurality of coils (multi-coils) in the space underneath the substantially flat structure.

The bottom drawing of Fig. 3 shows a top view of the flow deviator (again with the contact pad removed). Specifically, the drawing illustrates the airflow from the air inflow opening 33 to the first channels 21 (white arrows illustrating cold air) and the airflow from the second channels 22 to the air exhaust opening 34 (black arrows illustrating hot air).

The two flows are in contact with each other only via the interface (space between the top surface of the contact pad and the charge device), left by the pins 11 of the contact pad. This flow separation is ensured by the particular shape of the flow deviator channels explained above with reference to Fig. 2 and a closure of the overall structure at the bottom by a board avoiding air leakage. In this way, one can allow "fresh" (cold) air towards the interface while the other one allows removal of the heated air, thus avoiding overheating in the car cockpit.

Moreover, the figure also shows exemplary dimensions of the substantially flat structure. The width (smaller edge of the rectangle) may have a size of about 85mm (without the ribs 13, a1) or 95mm (with the ribs 13, a2). The length (larger edge of the rectangle) may have a size of about 185mm (without the ribs 13, b1) or 195mm (with the ribs 13, b2).

The overall thickness of the substantially flat structure, together with the contact pad and the pins or spacers (not shown) is in a range of approximately 3 to 5mm, more preferably from 3.5 to 4.5mm. Such a comparatively thin structure ensures a good charging behavior, since the transmitting and receiving coils can thus be placed close to each other.

Fig. 4 is a more detailed illustration of the contact pad taken alone.

The top drawing of Fig. 4 shows a side view of the contact pad. The overall thickness thereof, including the height of the pins (e) is, in an exemplary, non-limiting embodiment in the order of 2mm.

The bottom drawing of Fig. 4 shows a top view of the contact pad 1 a according to an example of the first embodiment of the present invention. The dimensions c of the smaller sides (edges) of the rectangle (first side 41 with the air inflow opening and second side 42 with the air exhaust opening) and d of the larger size of the rectangle (third side 43) are preferably the same as the corresponding dimensions a1 and b1 of the substantially flat structure of the flow deviator.

The bottom drawing of Fig. 4 further illustrates the pins 11 and the holes 12.

The pins 11 are in direct contact with the mobile phone or other appliance to be charged and guarantee sufficient space between the mobile phone and the contact pad base for the passing through of the air.

In a preferred example of the first embodiment, shown in the drawing, the arrangement of the holes 12 follows a specific pattern. Each air flow channel is connected to one row (in the left and right direction) of holes 12. As can be seen from Fig. 3, the first 21 and second 22 channels alternate. In the rows of holes 12 connected to the first channels (i.e. the second, fourth, sixth and eighth row, counted from the top of the bottom drawing of Fig. 4), there is an increasing size from the left-hand side 41, i.e. the side of the air inflow opening which the first fan 3 blowing air to the inside of the substantially flat structure is mounted on, towards the right-hand side 42. In the rows of holes 12 connected to the second channels (i.e. the first, third, fifth, seventh and ninth rows in the exemplary drawing), the size is decreasing from the left-hand side 41 to the right-hand side 42. The size of the holes are different in order to compensate for the distance from the fans 3 and thus to have almost the same flow conditions along the entire appliance (mobile) surface.

### (Second Embodiment)

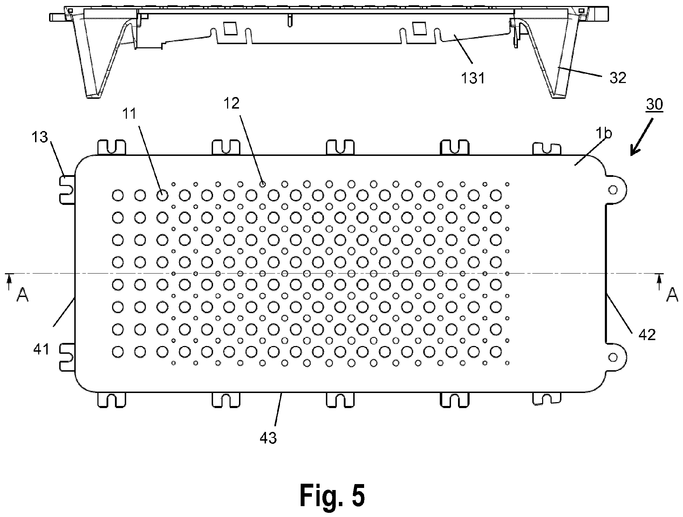

A second embodiment is shown in Figs. 5 to 9. This embodiment involves the use of two fans in order to have two symmetrical air flows from each air inflow opening to the surface of the appliance to be charged. Thus, in this case both fans blow the air into the flow deviator, allowing a better device surface cooling but not avoiding the car cockpit heating.

In the second embodiment it is also possible to directly mount air conditioning pipes to the two air inflow openings instead of using fans. In this case (not illustrated in the drawings), an air conditioning system, in particular, an air conditioning system of a vehicle is connected to the air inflow openings, instead of dedicated fans 3.

Fig. 5 shows a side view and a top view of a cooling device 30 according to an example of the second embodiment.

The bottom drawing of Fig. 5 shows a top view of the cooling device 30. The cooling device is covered by contact pad 1 b having pins 11 and holes 12. Further, ribs 13 of the flow deviator extending beyond the rectangular shape are shown.

The pattern of the holes 12 in this embodiment is different from that in the example of the first embodiment illustrated in Fig. 4. In the example of the second embodiment illustrated in Fig. 5, there is again a plurality of rows of holes 12, each of which is connected to one air flow channel, as will be explained below with reference to the following drawings. However, in this case the size distribution of holes is the same in each of the rows. More specifically, the size of the holes 12 increases from the periphery (left and right hand sides) towards the center of each row, so that the holes are the largest in the middle of each row, where the inflowing air from both air inflow openings meets. In other words, in each row the hole size increases with increasing distance to the nearest air inflow opening. Again, the size variation of the holes serves to compensate for the distance from the (nearest) fan and thus allowing approximately the same flow conditions along the surface of the appliance to be charged.

The top drawing of Fig. 5 shows a side view of a cooling device according to the second embodiment, viewed from one of the longer sides of the rectangle. Specifically, the top view shows a section view along the line A-A in the bottom drawing.

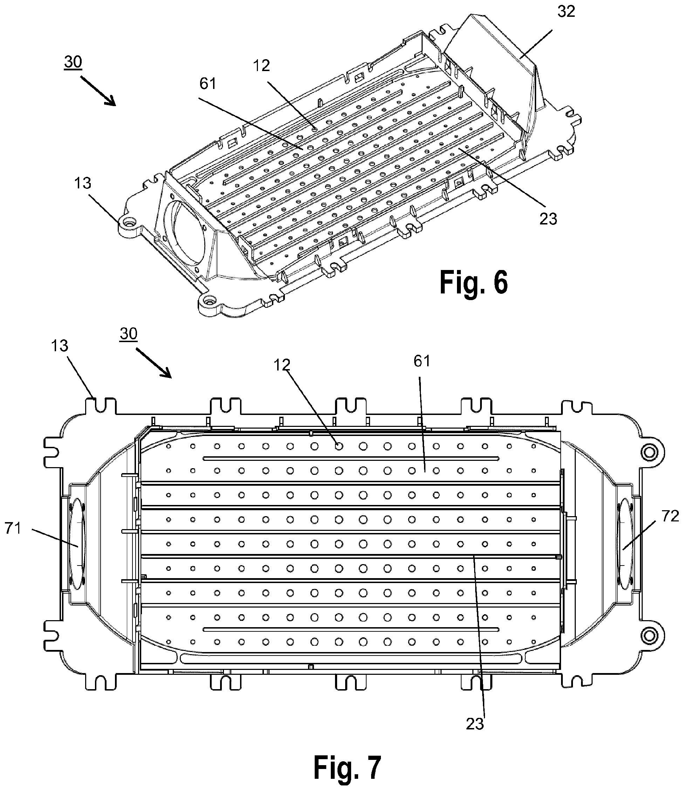

The overall construction and shape of the cooling device is substantially the same as that illustrated in Fig. 3 for the first embodiment. Again, the flow deviator comprises a substantially flat structure 131 and a side portion 32. The substantially flat structure has been denoted with a different reference numeral (131) since the internal structure thereof considerably differs from that of the substantially flat structure 31 of the first embodiment. This will be explained below with reference to Figs. 6 to 8.

Also, the overall dimensions are the same in both embodiments. In particular, the exemplary dimensions discussed with reference to Figs. 3 and 4 are also applicable in case of the second embodiment. This portion of the description of the first embodiment is therefore not repeated in this place.

Fig. 6 illustrates an isometric view of a cooling device 30 from below in accordance with the second embodiment. In particular, it can be seen that the substantially flat structure comprises a plurality of air flow channels 61 extending from the first to the second side, i.e. from the first to the second air inflow opening, in a manner substantially parallel to the longer sides of the rectangular shape. Each of the channels 61 is connected to one row of air holes 12, which are the largest in the center of the channel and have a decreasing size towards each of the air inflow openings.

The walls 23 extend from the contact pad substantially downwards (upwards in the drawing) and substantially parallel to the longer sides of the rectangular structure. However, the walls do not have the specific shape of the first embodiment, to separate the space of the flow deviator into two chambers each being connected only to a single one of the air flow openings (inflow opening and exhaust opening). Therefore, in the illustrated example the walls do not substantially deviate from the shape parallel to the sides of the rectangle. Each of the airflow channels 61 thus performs the same function of conveying air from one of the air inflow openings to the interface between the contact pad and the electric appliance placed thereon, through the respective holes 12. Contrary to the first embodiment, no airtight isolation between channels of two different kinds is required.

In the second embodiment, the internal walls 23 have only two functionalities: to support the contact pad and to guide the airflow. The third functionality of the walls 23 in the first embodiment (dividing the flow deviator into two main chambers) is lost in the second embodiment. In fact, in the second embodiment the chambers are connected between them (both fans 3 are blowing air to the center of the deviator).

The cool air leaves the device through the air holes 12 and, after having been heated in the interface between the contact pad and the appliance, leaves the interface to the sides thereof, without passing once more through the cooling device.

The side portions 32 are adapted to either mount a fan thereto or to connect an air conditioning pipe (both versions not shown).

Fig. 7 is a bottom view of the cooling device 30 according to the second embodiment.

In particular, the drawing also shows the two air inflow openings 71 and 72 on the opposite smaller sides of the substantially flat structure of the flow deviator.

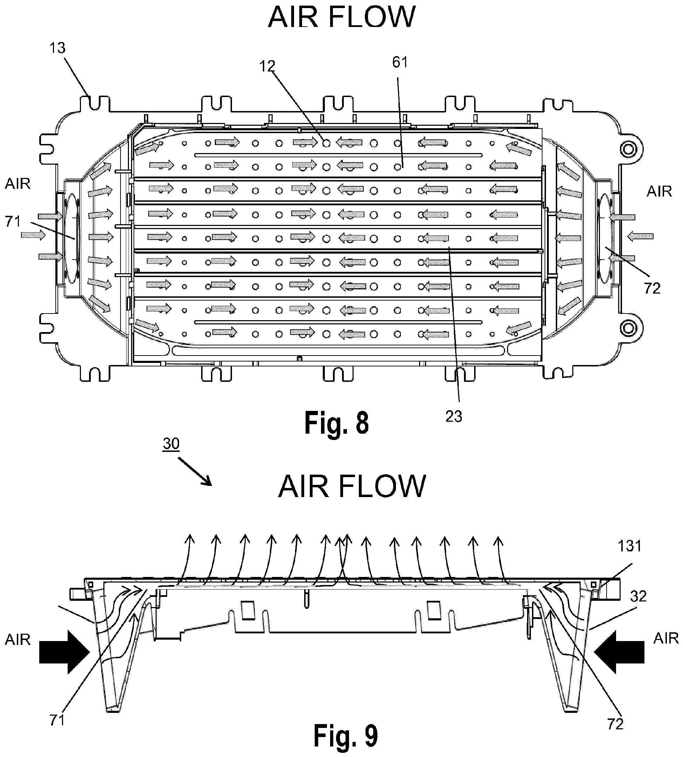

A further illustration of the bottom view of a cooling device according to the second embodiment is given in Fig. 8. In a manner similar to that in Fig. 3 for the first embodiment, the airflow from the air inflow openings 71 and 72 is illustrated by means of arrows. In view of the overall symmetry and the same functionality of the airflow openings on both sides, as an inflow opening, no distinction between the channels must be made, and accordingly only a single kind of arrow is shown.

Finally, Fig. 9 illustrates the airflow in an example of the second embodiment in a side view (specifically: a section view along the line A-A of Fig. 5). As can be easily seen therefrom, the air enters the cooling device in the air inflow openings 71 and 72 of the side portion 32 of the flow deviator and leave the cooling device 130 through the air holes of the contact pad.

The present invention, however, is not limited to the exemplary embodiments, the detailed description of which is given above with reference to exemplary drawings.

For instance, in an embodiment of the present invention there is only a single air inflow opening on one of the sides of the substantially flat structure. The overall channel structure of such an embodiment is, in principle, the same as in the second embodiment illustrated above. However, in that case preferably the size of the holes is chosen not so that the largest holes are in the center, but the largest holes are preferably situated at the end of each row of holes that is opposite to the air inflow opening. So, again the smallest holes are the closest to the air inflow opening.

Also, there may be embodiments in which there is no separation into a plurality of individual airflow channels. However, it has to be noted that in any embodiment having both an air inflow opening and an air exhaust opening, i.e. in all embodiments wherein the heated air is sucked out through the cooling device, there must of course be at least two separated air flow channels.

A various number of variants are possible regarding the system placement, the air sources, the kinds and sizes of fans, and the space that would be left for moving coil mechanism or a multi-coils arrangement.

In order to have a water resistant assembly, waterproof fans and waterproof materials for the assembly are preferred. Another issue may be the noise generated by the fans. Preferably, either low-noise fans should be applied, or in case of the second embodiment or a single-airflow-hole solution, the air conditioning system should be directly applied.

The present invention as defined by the appended claims is not limited to those particular embodiments that have been described in detail above. The particular features of embodiments described herein can be combined as long as this does not lead to contradictions. A person skilled in the art is aware of further modifications of the described embodiments within the scope of the claims.

In summary, the present invention relates to a cooling device for an inductive charger for automotive as well as consumer applications. The cooling device is effective for guiding cool air towards an electric appliance positioned for performing inductive charging. In particular, the cooling device according to the present invention is suitable for charging electronic appliances such as smart phones or tablet computers. The cooling device enables an effective cooling concept which allows enhancement of the power of a wireless inductive charger to the order of up to at least 15W.

## Claims

1. A cooling device for enabling cooling of an electric appliance during inductive charging, comprising:
a contact pad (1; 1a; 1b) for placing thereon an electric appliance to be charged, said contact pad including
a plurality of air flow holes (12), and
a means (11) for establishing a predetermined distance between an upper surface of the contact pad (1; 1 a; 1 b) and a lower surface of an electric appliance placed on the contact pad (1; 1a; 1b); and
a flow deviator (2), said flow deviator (2) comprising a substantially flat structure (31; 131) provided underneath the contact pad (1; 1a; 1b) so as to be in contact with a lower surface of the contact pad (1; 1 a; 1 b), said flow deviator (2) including:
an air inflow opening (33; 71) arranged on a first side (41) of the substantially flat structure (31; 131), and
at least one air flow channel (21; 61) formed by walls (23) extending from the lower surface of the contact pad (1; 1a; 1b) in a thickness direction of the substantially flat structure (31; 131) and connected to said air inflow opening (33; 71) and to at least a part of the air flow holes (12) of the contact pad (1; 1a; 1b), for conveying the air from the air inflow opening (33; 71) to said at least a part of the air flow holes (12).

2. A cooling device according to claim 1, wherein said flow deviator (2) further including a second air flow opening (34; 72) arranged on a second side (42) of said substantially flat structure (31; 131), said second side (42) being substantially opposite to said first side (41).

3. A cooling device according to claim 2, wherein
said air inflow opening is a first air inflow opening (71) and said second air flow opening is a second air inflow opening (72), and
said at least one air flow channel (61) is further connected to said second air inflow opening (72).

4. A cooling device according to claim 3, including a plurality of air flow channels (61) extending substantially parallel to each other along a direction of a third side (43) of the substantially flat structure (131) connecting the first and the second sides (41, 42), each of the air flow channels (61) being connected to a respective portion of the air flow holes (12) of the contact pad (1b).

5. A cooling device according to any of claims 1 to 4, wherein said air inflow opening or air inflow openings (33; 71, 72) are configured so as to be connectable to respective fans (3) for blowing air into the at least one air flow channel (21; 61) through the respective air inflow opening (33; 71, 72).

6. A cooling device according to any of claims 1 to 4, wherein said air inflow opening or air inflow openings (33; 71, 72) are configured so as to be connectable to an air conditioning system, in particular an air conditioning system of a vehicle, for providing air to the at least one air flow channel (21; 61) through the air flow opening or air flow openings (33; 71,72).

7. A cooling device according to any of claims 1 to 6, wherein the air flow holes (12) of the contact pad (1b) have a varying size, the size increasing with the distance to the nearest air inflow opening (33; 71, 72).

8. A cooling device according to claim 2, wherein
said second air flow opening is an air exhaust opening (34),
said at least one air flow channel is at least one first air flow channel (21) connected to a first part of the plurality of air flow holes (12),
the flow deviator (2) further including at least one second air flow channel (22) formed by walls (23) extending from the lower surface of the contact pad (1a) in a thickness direction of the substantially flat structure (31) and connected to said air exhaust opening (34) and to a second part of said plurality of air flow holes (12) of the contact pad (1a), different from said first part of said plurality of air flow holes (12), for conveying the air from the second part of the air flow holes (12) to said air exhaust opening (34).

9. A cooling device according to claim 8, wherein said flow deviator (2) including a plurality of first and second air flow channels (21, 22) extending substantially parallel to each other along a direction of a third side (43) of the substantially flat structure (31) connecting the first and the second side (41, 42), the first and second air flow channels (21, 22) alternating in a direction parallel to the first and second sides.

10. A cooling device according to claim 8 or 9, wherein said air inflow opening (33) and said air exhaust opening (34) are configured so as to be connectable to a first and a second fan (3), respectively, the first fan (3) being for blowing air into the at least one first air flow channel (21) through the air inflow opening (33), the second fan (3) being for sucking the air out of the at least one second air flow channel (22) through the air exhaust opening (34).

11. A cooling device according to any of claims 8 to 10, wherein the air flow holes (12) of the contact pad (1 a) have a varying size, wherein the size of the air holes (12) connected to the at least one first air flow channel (21) increases with increasing distance from the air inflow opening (33), and the size of the air holes (12) connected to the at least one second air flow channel (22) increases with increasing distance from the air exhaust opening (34).

12. A cooling device according to claim 5 or 10, further comprising the one or two fans (3).

13. Wireless charging equipment comprising:
a cooling device (30) according to any of claims 1 to 12,
a board forming a lower closure at the bottom of the substantially flat structure (31; 131) of the flow deviator (2) of said cooling device (30), and
one or more transmission coils for transmitting electric energy to an electric appliance placed on the contact pad (1) of said cooling device (30).

14. A wireless charging device according to claim 13, wherein said board is a printed circuit board having the one or more transmission coils placed thereon and/or connected thereto.

15. A wireless charging device according to claim 14, wherein
said board is a detection printed circuit board comprising sensing means for sensing placement of an electric appliance on the contact pad and positioning of a receiving coil included in said electric appliance for receiving energy transmitted by said one or more transmission coils,
there is only a single transmission coil that is movably arranged underneath the bottom board, and
said sensing means is configured to send a signal to control a moving means for moving the transmission coil in accordance with a sensing result, in order to achieve an optimal alignment of the transmission coil with respect to the receiving coil.
